(19) Europäisches Patentamt
European Patent Office
Office européen des brevets

(11) Veröffentlichungsnummer: **0 175 244**
**B1**

(12) # EUROPÄISCHE PATENTSCHRIFT

(45) Veröffentlichungstag der Patentschrift: **11.04.90**

(51) Int. Cl.$^5$: **G 03 F 7/021,** G 03 F 7/09

(21) Anmeldenummer: **85111329.0**

(22) Anmeldetag: **07.09.85**

(54) **Lichtempfindliches Aufzeichnungsmaterial und Verfahren zu seiner Herstellung.**

(30) Priorität: **15.09.84 DE 3433911**

(43) Veröffentlichungstag der Anmeldung:
**26.03.86 Patentblatt 86/13**

(45) Bekanntmachung des Hinweises auf die Patenterteilung:
**11.04.90 Patentblatt 90/15**

(84) Benannte Vertragsstaaten:
**DE FR GB IT SE**

(56) Entgegenhaltungen:
**EP-A-0 008 038**
**EP-A-0 162 691**
**DE-A-1 772 172**
**DE-A-2 523 719**
**DE-A-3 516 387**
**GB-A-1 339 663**
**US-A-3 136 637**

(73) Patentinhaber: **HOECHST AKTIENGESELLSCHAFT**
**Postfach 80 03 20**
**D-6230 Frankfurt am Main 80 (DE)**

(72) Erfinder: **Michel, Manfred, Dr. Dipl.-Chem.**
**c/o Hoechst do Brasil Av. Jorge BeiMaluf**
**2073/2173**
**CEP 08600 Suzano-Sp (BR)**
Erfinder: **Sprintschnik Gerhard, Dr. Dipl.-Chem.**
**Rossbachhöhe 30**
**D-6204 Taunusstein (DE)**

**EP 0 175 244 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

**Beschreibung**

Die Erfindung betrifft ein negativ arbeitendes lichtempfindliches Aufzeichnungsmaterial für die Herstellung von Flachdruckplatten sowie ein Verfahren zu seiner Herstellung.

Negativ arbeitende vorsensibilisierte Flachdruckplatten enthalten gewöhnlich Diazoniumsalz-Polykondensationsprodukte, insbesondere solche, die außer Diazoniumsalzeinheiten noch Einheiten von nicht lichtempfindlichen kondensationsfähigen Verbindungen, z.B. von aromatischen Aminen, Phenolen, aromatischen Thioethern, aromatischen Kohlenwasserstoffen, heterocyclischen Verbindungen oder organischen Säureamiden enthalten. Derartige Druckplatten sind in der US—A 3 867 147 beschrieben. Wenn die lichtempfindliche Schicht dieser Druckplatten im wesentlichen nur aus dem Polykondensationsprodukt besteht, lassen sich die belichteten Platten leicht mit rein wäßrigen Lösungen, die zweckmäßig Netzmittel enthalten, entwickeln. Diese Platten sind jedoch nur für einen mittleren Auflagenbereich geeignet. Will man höhere Druckauflagen erreichen, so ist es in der Regel erforderlich, ein wasserunlösliches polymeres Bindemittel, z.B. Polyvinylacetale, zuzusetzen. Die dabei erhaltenen Druckplatten erfordern jedoch für eine glatte Entwicklung zumeinst den Zusatz von organischen Lösemitteln zum Entwickler. Bei Verwendung von rein wäßrigen Entwicklerlösungen bleiben Schichtpartikel ungelöst, die den Entwickler verunreinigen und sich auf bildfreien Stellen der damit zu entwickelnden Platten abscheiden können.

Man hat deshalb Bindemittel eingesetzt, die sich in wäßrig-alkalischen Lösungen lösen. Druckplatten dieses Typs sind in den EP—A 0 048 876 und 0 071 881 beschrieben. Diese Platten lassen sich leicht mit rein wäßrigen Entwicklern fladenfrei entwickeln und liefern gute Druckauflagen. Sie zeigen jedoch häufig eine verzögerte Farbannahme in der Druckmaschine. Als Ursache hierfür wird eine Reaktion von Schichtbestandteilen mit hydrophilen Konservierungsmitteln angenommen, die nach dem Entwickeln zum Schurz der Platte aufgebracht werden. Solche Reaktionen können im Dunklen oder auch am Licht eintreten. Eine weitere Ursache kann eine Hydrophilierung der Schichtoberfläche sein, die durch Kontakt der Schicht mit üblicherweise verwendeten alkalischen Druckhilfsmitteln zustande kommt.

Ein weiterer Nachteil dieser Druckplatten ist es, daß die Druckauflage bei Verwendung alkalischer Feuchtwässer herabgesetzt wird. Dies ist wahrscheinlich auf die relativ gute Alkalilöslichkeit der Bindemitel zurückzuführen.

Weiterhin weisen die meisten mit wäßrigen Entwicklern entwickelten Druckplatten eine weichere Gradation auf als die mit organischen Lösemitteln entwickelten. Dadurch wird die Ermittlung der richtigen Belichtungszeit mittels eines Stufenkeils erheblich erschwert, und es tritt im Druck eine im Vergleich zur gerasterten Vorlage sehr deutliche Tonwertzunahme ein. Dennoch hat man bisher diese Nachteile wegen der ökologischen Vorteile der wäßrigen Entwicklung in Kauf genommen.

Aus der US—A 3 136 637 ist es bekannt, die Wasserempfindlichkeit und Hydrophilie von Druckplatten auf der Basis von Diazoniumsaltz-Formaldehyd-Kondensationsprodukten dadurch zu vermindern, daß man auf die lichtempfindliche Schicht eine Deckschicht aus einem wasserunlöslichen Harz aufbringt. Die Entwicklung muß hier wieder mit einem Entwickler erfolgen, der organische Lösemittel enthält.

In der DE—B 15 22 501 ist eine ähnliche Druckplatte beschrieben, die auf einer wasserlöslichen lichtempfindlichen Schicht aus Diazoniumsalz-Kondensationsprodukt eine wasserunlösliche lichtempfindliche Schicht trägt, die aus einem 1,4-Chinondiazid und gegebenenfalls einem wasserunlöslichen Harz besteht. Dieses Material hat eine relativ geringe Lichtempfindlichkeit, und die Druckauflage der daraus erhaltenen Druckformen ist vergleichsweise niedrig.

In der DE—A 25 23 719 ist ein lichtempfindliches Material beschrieben, das eine wasserlösliche lichtempfindliche Schicht auf der Basis von Aziden, Chalkonen oder Diazoniumsalz-Kondensaten und wasserlöslichen Polymeren und eine darüberliegende wasserdurchlässige, in Wasser unlösliche Schicht aus einem organischen Kunstharz enthält.

Die Entwicklung erfolgt mit Wasser, wobei die unbelichteten Bereiche der wasserlöslichen lichtempfindlichen Schicht gelöst werden. Die darüberliegende Kunsttharzschicht muß dann durch Reiben entfernt werden. Diese Art der Entwicklung hängt sehr stark vom Geschick des Verarbeiters ab; es besteht immer die Gefahr, daß dabei Bildteile der Schicht mit weggerissen werden oder daß die Deckschicht in den Nichtbildbereichen nicht sauber entfernt wird. Das Material eignet sich nicht für die automatische Entwicklung in einer Verarbeitungsstraße, und der Entwickler enthält natürlich ungelöste Partikel der Deckschicht. Auch ist die hier beschriebene Platte nicht für hohe Auflagen geeignet.

Schließlich ist es auch bekannt, positiv arbeitende lichtempfindliche Materialien auf der Basis von 1,2-Chinondiaziden mit wasserunlöslichen Deckschichten aus organischen Polymeren zu überziehen. So wird gemäß DE—A 24 26 159 ein Teil der Dicke einer 1,2-Chinondiazidschicht durch eine wasserunlösliche Polymerschicht ersetzt, um die Lichtempfindlichkeit zu erhöhen. Hier ist jedoch aufgrund einer zu geringen Haftung der Deckschicht die Druckaufglage nicht optimal. Es wird deshalb gemäß der DE—A 24 61 515 der oleophilen Deckschicht ein haftverbesserndes Mittel zugesetzt, um diesen Nachteil zu beheben. Als Haftungsmittel wird u. a. ein Silan verwendet. Als Entwickler werden wäßrige Lösungen verwendet, die erhebliche Mengen an organischen Lösemitteln enthalten. Die bei der Entwicklung ausgewaschenen Silanverbindungen bzw. deren Reaktionsprodukte bewirken eine raschere Verunreinigung des Entwicklers.

Es ist ferner aus der EP—A 0 008 038 bekannt, mit Wasser entwickelbare lichtempfindliche Schichten durch Aufbringen einer stabilen wäßrigen Dispersion eines wasserunlöslichen Polymeren, in der ein

Diazoniumsalz-Polykondensationsprodukt gelöst ist, zu erzeugen. Auch diese Materialien liefern keine optimalen Druckauflagen, da die Bildstellen eine gewisse Empfindlichkeit gegen Wasser und wäßrige Lösungen aufweisen.

Aufgabe der Erfindung war es, ein lichtempfindliches Aufzeichnungsmaterial für die Herstellung von Flachdruckplatten auf der Basis von Diazoniumsalz-Polykondensationsprodukten vorzuschlagen, das sich mit rein wäßrigen Lösungen entwickeln läßt, das Druckformen mit hoher Auflagenleistung ergibt, das sich sauber und ohne Abscheidung von Partikeln im Entwickler entwickeln läßt und das Bildbereiche mit guter und dauerhafter Farbannahme liefert.

Die Erfindung geht aus von einem lichtempfindlichen Aufzeichnungsmaterial mit einem Schichtträger, einer lichtempfindlichen Aufzeichnungsschicht, die als lichttempfindliche Verbindung ein Kondensationsprodukt aus wiederkehrenden Einheiten $A—N_2X$ und B enthält, die durch zweibindige, von einer kondensationsfähigen Carbonylverbindung abgeleitete Zwischenglieder verbunden sind, wobei die Einheiten $A—N_2X$ sich aus Verbindungen der allgemeinen Formel

$$(R^1—R^3—)_pR^2—N_2X$$

ableiten und wobei

X das Anion der Diazoniumverbindung,

p eine ganze Zahl von 1 bis 3

$R^1$ einen carbocyclischen oder heterocyclischen aromatischen Rest mit mindestens einer kondensationsfähigen Position,

$R^2$ eine Arylengruppe der Benzol- oder Naphthalinreihe,

$R^3$ eine Einfachbindung oder eine der Gruppen:

$$—(CH_2)_q—NR^4—,\quad —O—(CH_2)_r—NR^4—,\quad —S—(CH_2)_r—NR^4—,$$

$$—S—CH_2—CO—NR^4—,\quad —O—R^5—O—,\quad —O—,$$

$$—S— \text{ oder } —CO—NR^4—$$

bedeuten, worin

q eine Zahl von 0 bis 5,

r eine Zahl von 2 bis 5,

$R^4$ Wasserstoff, eine Alkylgruppe mit 1 bis 5 C-Atomen, eine Aralkylgruppe mit 7 bis 12 C-Atomen oder eine Arylgruppe mit 6 bis 12 C-Atomen, und

$R^5$ eine Arylengruppe mit 6 bis 12 C-Atomen ist, und

B den von Diazoniumgruppen freien Rest eines aromatischen Amins, Phenols, Thiophenols, Phenolethers, aromatischen Thioethers, aromatischen Kohlenwasserstoffs, einer aromatischen heterocyclischen Verbindung oder eines organischen Säureamids bedeutet,

wobei das Kondensationsprodukt im Mittel 0,01 bis 50 Einheiten B je Einheit $A—N_2X$ enthält, und als Bindemittel ein wasserunlösliches, in wäßrig-alkalischen Lösungen lösliches Polymeres enthält, und einer Deckschicht, die ein wasserunlösliches Homo- oder Mischpolymerisat eines Alkylacrylats oder Alkylmethacrylats mit 1 bis 12 C-Atomen in der Alkylgruppe, eines Vinylesters einer Carbonsäure mit 2 bis 12 C-Atomen, eines Vinylalkylethers mit 2 bis 8 C-Atomen in der Alkylgruppe oder einer vinylaromatischen Verbindung mit 8 bis 12 C-Atomen enthält, über der lichtempfindlichen Aufzeichnungsschicht.

Das erfindungsgemäße Aufzeichnungsmaterial ist dadurch gekennzeichnet, daß die Deckschicht durch Beschichten mit einer stabilen wäßrigen Dispersion des wasserunlöslichen Homo- oder Mischpolymerisats und Trocknen hergestellt worden ist.

Die Homo- oder Mischpolymerisate sind bevorzugt nicht in wäßrigen Alkalien löslich.

Erfindungsgemäß wird weiter ein Verfahren zur Herstellung eines lichtempfindlichen Aufzeichnungsmaterials vorgeschlagen, bei dem auf einen Schichtträger eine lichtempfindliche Aufzeichnungsschicht der vorstehend angegebenen Zusammensetzung und eine Deckschicht aufgebracht werden.

Das erfindungsgemäße Verfahren ist dadurch gekennzeichnet, daß man zur Erzeugung der Deckschicht eine stabile wäßrige Dispersion des wasserunlöslichen Homo- oder Mischpolymerisats auf die Aufzeichnungsschicht aufbringt und trocknet.

Gemäß einer bevorzugten Ausführungsform enthält die Deckschicht außer dem wasserunlöslichen Homo- oder Mischpolymerisat ein Diazoniumsalz-Polykondensationsprodukt, das bevorzugt wasserlöslich ist.

Die Deckschicht hat bevorzugt ein Schichtgewicht von 0,2 bis 1 $g/m^2$.

Wenn die Deckschicht ein Diazoniumsalz-Kondensationsprodukt enthält, kann dieses grundsätzlich den gleichen Aufbau haben, wie er oben für die Bestandteile der lichtempfindlichen Schicht beschrieben wurde. Des Anion des Salzes kann dabei vorzugsweise so beschaffen sein, daß das Salz wasserlöslich ist. Beispiele für geeignete Anionen sind Sulfate, Chloride, Phosphate und aliphatische Sulfonate. Das Diazoniumsalz-Kondensationsprodukt kann, wenn es vorhanden ist, in der Deckschicht bevorzugt in einem

Mengenanteil von 10 bis 50 Gew.-%, bezogen auf die nichtflüchtigen Bestandteile der Schicht, enthalten sein.

Die Bestandteile der Deckschicht werden in Form einer stabilen wäßrigen Dispersion auf die lichtempfindliche Schicht aufgebracht. Die Dispersion enthält in üblicher Weise oberflächenaktive Dispergierhilfsmittel und bzw, oder Schutzkolloide. Die Herstellung und Verarbeitung der Beschichtungsdispersion ist an sich bekannt und erfolgt z.B. in gleicher Weise wie es in der EP—A 0 008 038 beschrieben ist.

Die lichtempfindliche Schicht — oder gegebenenfalls die untere lichtempfindliche Schicht — enthält in bekannter Weise Diazoniumsalz-Polykondensationsprodukte, die in der Regel wasserunlöslich sind. Wie bereits erwähnt, sind diese Kondensationsprodukte in der US—A 3 867 147 beschrieben. Die Schicht enthält ferner ein alkalilösliches Polymeres. Geeignete Polymere sind in den EP—A 0 071 881 und 0 048 876 (= US—A 4 387 151) beschrieben. Bevorzugt werden Carboxylgruppen enthaltende Mischpolymerisate und Polymere mit Sulfonylurethangruppen. Die Schichten enthalten im allgemeinen 5 bis 90, bevorzugt 10 bis 70 Gew.-% Diazoniumverbindung und 95 bis 10, bevorzugt 90 bis 30 Gew.-% polymeres Bindmittel. Sie können ferner Säuren, z.B. Phosphorsäure; Weichmacher, Haftvermittler, Farbstoffe, Pigmente, Farbbildner und andere Polymere enthalten.

Als Schichtträger wird vorzugsweise Aluminium verwendet, das mechanisch, chemisch und/oder elektrochemisch aufgerauht und gegebenenfalls anodisiert sein kann. Andere geeignete Materialien sind z.B. Stahl, Chrom und andere für den Flachdruck übliche Trägermaterialien.

Die Verarbeitung erfolgt in bekannter Weise durch bildmäßiges Belichten und Auswaschen der unbelichteten Schichtbereiche mit einem wäßrig-alkalischen Entwickler, der im allgemeinen einen pH-Wert im Bereich von 8 bis 14, vorzugsweise von 10 bis 13, aufweist. Außer Alkalien und Puffersalzen kann der Entwickler noch Netzmittel und andere übliche Zusätze enthalten. Vorzugsweise werden keine organischen Lösemittel zugesetzt.

Bei der Entwicklung werden die unbelichteten Anteile der lichtempfindlichen Schicht sowie die entsprechenden Bereiche der Deckschicht im Entwickler gelöst bzw. dispergiert. Die Deckschichtbestandteile werden an diesen Stellen leicht im Entwickler dispergiert, während sie an den belichteten Stellen mindestens zum überwiegenden Teil auf der lichtempfindlichen Schicht verbleiben. Diese Differenzierung wird durch Zusatz von Diazoniumsalz-Kondensationsprodukten zur Deckschicht gefördert. Die wasserunlöslichen Bestandteile der Deckschicht werden offenbar durch die darin verteilten Dispergierhilfsmittel, rasch in dem Entwickler zu einer stabilen Dispersion verteilt, d. h. es werden keine makroskopisch sichtbaren Fladen oder Partikel gebildet, die sich absetzen.

Über den lichtgehärteten Bereichen der lichtempfindlichen Schicht bleibt die Deckschicht erhalten und fest mit der darunterliegenden Schicht verbunden. Die Schicht weise an diesen Stellen eine hervorragende Oleophilie auf, d. h. die Bildstellen der Druckform nehmen Druckfarbe bereits nach Durchlauf der ersten Druckbogen an. Auch die Druckauflage wird durch die Deckschicht erhöht. Die Druckformen haben eine deutklich steilere Gradation als entsprechende Druckformen, die keine Deckschicht der hier beschriebenen Art aufweisen.

Die folgenden Beispiele beschreiben bevorzugte Ausführungsformen der Erfindung. Prozentangaben und Mengenverhältnisse sind, wenn nichts anderes angegeben ist, in Gewichtseinheiten zu verstehen. Gewichtsteile (Gt) und Volumenteile (Vt) stehen zueinander im Verhältnis von g zu $cm^3$.

## Beispiel 1

Eine Beschichtungslösung aus

97,0 Gt des Umsetzungsprodukts von Polyvinylbutyral (Molekulargewicht 70—80.000; 71 Gew.-% Vinylbutyral-, 2 Gew.-% Vinylacetat- und 27 Gew.-% Vinylalkohol-Einheiten) mit Propenylsulfonylisocyanat (Erweichungspunkt ca. 161°C, Säurezahl 18,0),
48,3 Gt eines Diazoniumsalz-Polykondensationsprodukts, hergestellt aus 1 mol 3-Methoxydiphenylamin-4-diazoniumsulfat und 1 mol 4,4'-Bis-methoxymethyl-diphenylether in 85%iger Phosphorsäure und isoliert als Mesitylensulfonat,
4,8 Gt Phosphorsäure (85%),
3,5 Gt Viktoriareinblau FGA (C.I. Basic Blue 81) und
1,6 Gt Phenylazodiphenylamin in
3500 Gt 2-Methoxy-ethanol und
1036 Gt Tetrahydrofuran

wurde auf eine elektrochemisch aufgerauhte und anodisierte Aluminiumfolie, die mit Polyvinylphosphonsäure nachbehandelt worden war, aufgebracht. Das Schichtgewicht betrug nach dem Trocknen 0,8 $g/m^2$. Auf die trockene Schicht wurde eine wäßrige Emulsion auf der Basis von Polystyrol aufgetragen (Styrofan 2D; BASF; anionisches Emulgatorsystem, Teilchengröße 0,5 µm, Reißfestigkeit des Films 100 $kg/cm^2$). Das Gewicht der trockenen Schicht betrug 0,5 $g/m^2$. Die vorsenbilisierte Druckplatte wurde unter einer Negativvorlage 35 Sekunden mit einer Metallhalogenid-Lampe von 5 kW Leistung belichtet.

Die belichtete Schicht wurde mit einer Entwickler-Lösung folgender Zusammensetzung:

5 Gt Natriumlaurylsulfat,
1,5 Gt Natriummetasilikat × 5 $H_2O$,
1 Gt Trinatriumphosphat × 12 $H_2O$,
92,5 Gt Wasser

mittels eines Plüschtampons behandelt, wobei die nichtbelichteten Schichtbereiche entfernt wurden, dann mit Waser abgespült und abgetrocknet.

In einer Offsetdruckmaschine wurden auf einen Zylinder nebeneinander zwei Platten eingespannt: die oben hergestellte sowie eine gleiche Platte ohne Deckschicht. Jede Platte wurde jeweils zur Hälfte mit einem stark alkalischen Walzenwaschmittel ("Feuchtofix") behandelt, während die andere Hälfte unbehandelt blieb. Die 4 Bereiche am Plattenzylinder nahmen unterschiedlich schnell Farbe an. Die folgende Tabelle gibt jewils die Anzahl der durchgelaufenen Druckbogen bis zur vollständigen Farbannahme an.

| | Platte mit | Platte ohne |
|---|---|---|
| | Deckschicht | |
| alkalisch behandelt | 30 | 100 |
| unbehandelt | 15 | 20 |

Die Tabelle zeigt, daß die erfindungsgemäß hergestellte Platte weit weniger alkaliempfindlich war als eine gleiche Platte ohne Deckschicht.

Die Gradation im eingefärbten Zustand, d. h. die Zahl der nicht voll gedeckten Zwischenstufen, betrug bei der erfindungsgemäßen Platte 2, bei der Vergleichsplatte 4 (KALLE Stufenkeil BK01). Die Druckauflage lag um 20% höher als bei der Vergleichsplatte.

Beispiel 2

Es wurde verfahren wie in Beispiel 1 mit folgenden Unterschieden:

a) das Bindemittel der organischen Beschichtungslösung wurde durch die gleiche Menge eines Copolymerisats aus Styrol und Maleinsäureanhydrid (1:1) ersetzt;

b) entwickelt wurde mit einer Lösung von

5 Gt Triethanolammoniumsalz des Laurylsulfats,
1 Gt Natriummetasilikat × 5 $H_2O$ und
1,5 Gt Trinatriumphosphat × 12 $H_2O$ in
92,5 Gt Wasser;

c) die Deckschicht wurde hergestellt durch Aufbringen einer Lösung aus

3 Gt einer wäßrigen Emulsion von Polyvinylisobutylether (Teilchengröße 0,5 bis 3 µm)
1 Gt eines Diazoniumsalz-Polykondensationsprodukts, hergestellt aus 1 mol 3-Methoxydiphenylamin-4-diazoniumsulfat und 1 mol 4,4'-Bis-methoxymethyl-diphenylether in 85%iger Phosphorsäure und isoliert als Methansulfonat und
1 Gt eines nichtionischen Netzmittels auf der Basis eines ethoxylierten Alkylphenols ("Triton X 100").

Das Gewicht der trocknenen Deckschicht betrug 0,65 g/m$^2$. Die Verarbeitung erfolgte analog Beispiel 1. Die Alkaliempfindlichkeit war noch geringer als bei Verwendung einer Deckschicht ohne Diazoverbindung. Besonders auffällig ist die erleichterte Beurteilung der Belichtungszeit (harte Gradation) sowie der verbesserte visuelle Kontrast nach der Belichtung.

Beispiel 3

Es wurde verfahren wie in Beispiel 1, als polymeres Bindemittel der Deckschicht wurde eine Emulsion eines Terpolymerisats aus Vinylchlorid, Ethylen und Vinylacetat verwendet. Die Ergebnisse waren ähnlich denen in Beispiel 1 und 2.

**Patentansprüche**

1. Lichtempfindliches Aufzeichnungsmaterial mit einem Schichtträger, einer lichtempfindlichen Aufzeichnungsschicht, die als lichtempfindliche Verbindung ein Kondensationsprodukt aus wiederkehrenden Einheiten A—$N_2X$ und B enthält, die durch zweibindige, von einer kondenksatonsfähigen

Carbonylverbindung abgeleitete Zwischenglieder verbunden sind, wobei die Einheiten A—$N_2X$ sich aus Verbindungen der allgemeinen Formel

$$(R^1—R^3—)_pR^2—N_2X$$

ableiten und wobei

X das Anion der Diazoniumverbindung,

p eine ganze Zahl von 1 bis 3

$R^1$ einen carbocyclischen oder heterocyclischen aromatischen Rest mit mindestens einer kondensationsfähigen Position,

$R^2$ eine Arylengruppe der Benzol- oder Naphthalinreihe,

$R^3$ eine Einfachbindung oder eine der Gruppen:

$$—(CH_2)_q—NR^4—,\ —O—(CH_2)_r—NR^4—,\ —S—(CH_2)_r—NR^4—,$$

$$—S—CH_2—CO—NR^4—,\ —O—R^5—O—,\ —O—,$$

$$—S—\ \text{oder}\ —CO—NR^4—$$

bedeuten, worin

q eine Zahl von 0 bis 5,

r eine Zahl von 2 bis 5,

$R^4$ Wasserstoff, eine Alkylgruppe mit 1 bis 5 C-Atomen, eine Aralkylgruppe mit 7 bis 12 C-Atomen oder eine Arylgruppe mit 6 bis 12 C-ATomen, und

$R^5$ eine Arylengruppe mit 6 bis 12 C-Atomen ist, und

B den von Diazoniumgruppen freien Rest eines aromatischen Amins, Phenols, Thiophenols, Phenolethers, aromatischen Thioethers, aromatischen Kohlenwasserstoffs, einer aromatischen heterocyclischen Verbindung oder eines organischen Säureamids bedeutet,

wobei das Kondensationsprodukt im Mittel 0,01 bis 50 Einheiten B je Einheit A—$N_2X$ enthält, und als Bindemittel ein wasserunlösliches, in wäßrig-alkalischen Lösungen lösliches Polymeres enthält, und einer Deckschicht, die ein wasserunlösliches Homo- oder Mischpolymerisat eines Alkylacrylats oder Alkylmethacrylats mit 1 bis 12 C-Atomen in der Alkylgruppe, eines Vinylesters einer Carbonsäure mit 2 bis 12 C-Atomen, eines Vinylalkylethers mit 2 bis 8 C-Atomen in der Alkylgruppe oder einer vinylaromatischen Verbindung mit 8 bis 12 C-Atomen enthält, über der lichtempfindlichen Aufzeichnungsschicht, dadurch gekennzeichnet, daß die Deckschicht durch Beschichten mit einer stabilen wäßrigen Dispersion des wasserunlöslichen Homo- oder Mischpolymerisats und Trocknen hergestellt worden ist.

2. Aufzeichnungsmaterial nach Anspruch 1, dadurch gekennzeichnet, daß die Deckschicht zusätzlich zu dem wasserunlöslichen Polymeren ein Diazoniumsalz-Kondensatonsprodukt der in Anspruch 1 angegebenen Definition enthält.

3. Aufzeichnungsmaterial nach Anspruch 1, dadurch gekennzeichnet, daß die Deckschicht ein Schichtgewicht von 0,2 bis 1 g/$m^2$ hat.

4. Aufzeichnungsmaterial nach Anspruch 1, dadurch gekennzeichnet, daß die Deckschicht ferner ein oberflächenaktives Mittel enthält.

5. Aufzeichnungsmaterial nach Anspruch 1, dadurch gekennzeichnet, daß die Deckschicht ferner ein Schutzkoloid enthält.

6. Verfahren zur Herstellung eines lichtempfindlichen Aufzeichnungsmaterials, bei dem auf einer Schichtträger eine lichtempfindliche Aufzeichnungsschicht gemäß Anspruch 1, und eine Deckschicht auf diese Aufzeichnungsschicht aufgebracht wird, dadurch gekennzeichnet, daß man zur Erzeugung der Deckschicht eine stabile wäßrige Dispersion eines wasserunlöslichen Polymeren auf die Aufzeichnungsschicht aufbringt und trocknet.

**Revendications**

1. Matériau reprographique photosensible comportant un support de couche, une couche reprographique photosensible qui contient, en tant que composé photosensible, un produit de condensation constitué de motifs répétitifs A—$N_2X$ et B qui sont reliés par des chaînons intermédiaires bivalents dérivés d'un composé carbonyle condensable, les motifs A—$N_2X$ dérivant de composés de formule générale

$$(R^1—R^3—)_pR^2—N_2X$$

dans laquelle

X représente l'anion du composé diazonium,

p est un nombre entier allant de 1 à 3,

$R^1$ représente un radical aromatique carbocyclique ou hétérocyclique comportant au moins une position susceptible de condensation,

$R^2$ représente un groupe arylène de la série du benzène ou du naphtalène,

$R^3$ représente une simple liaison ou l'un des groupes

$$-(CH_2)_q-NR^4-,\quad -O-(CH_2)_r-NR^4-,\quad -S-(CH_2)_r-NR^4-,$$

$$-S-CH_2-CO-NR^4-,\quad -O-R^5-O-,\quad -O-,$$

$$-S- \text{ ou } -CO-NR^4-$$

q étant un nombre allant de 0 à 5,

r étant un nombre allant de 2 à 5,

$R^4$ représentant un atome d'hydrogène ou un groupe alkyle ayant de 1 à 5 atomes de carbone, un groupe aralkyle ayant de 7 à 12 atomes de carbone ou un groupe aryle ayant de 6 à 12 atomes de carbone, et

$R^5$ étant un groupe arylène ayant de 6 à 12 atomes de carbone, et

B représente le radical exempt de groupe diazonium d'une amine aromatique, d'un phénol, d'un thiophénol, d'un phénoléther, d'un thioéther aromatique, d'un hydrocarbure aromatique, d'un composé aromatique hétérocyclique ou d'un amide organique,

le produit de condensation contenant en moyenne de 0,01 à 50 motifs B par motif $A-N_2X$, et qui contient, en tant que liant, un polymère insoluble dans l'eau, soluble dans des solutions aqueuses alcalines, et, sur la couche reprographique photosensible, une couche de recouvrement qui contient un homo- ou copolymère, insoluble dans l'eau, d'un acrylate d'alkyle ou méthacrylate d'alkyle ayant de 1 à 12 atomes de carbone dans le reste alkyle, d'un ester vinylique d'un acide carboxylique ayant de 2 à 12 atomes de carbone, d'un éther vinylalkylique ayant de 2 à 8 atomes de carbone dans le reste alkyle, ou d'un composé vinylaromatique ayant de 8 à 12 atomes de carbone, caractérisé en ce que la couche de recouvrement a été produite par enduction avec une dispersion aqueuse stable de l'homo- ou copolymère insoluble dans l'eau, puis séchage.

2. Matériau reprographique selon la revendication 1, caractérisé en ce que la couche de recouvrement contient, en plus du polymère insoluble dans l'eau, un produit de condensation de sel de diazonium selon la définition donnée dans la revendication 1.

3. Matériau reprographique selon la revendication 1, caractérisé en ce que la couche de recouvrement a un poids de couche de 0,2 à 1 $g/m^2$.

4. Matériau reprographique selon la revendication 1, caractérisé en ce que la couche de recouvrement contient en outre un agent tensioactif.

5. Matériau reprographique selon la revendication 1, caractérisé en ce que la couche de recouvrement contient en outre un colloïde protecteur.

6. Procédé pour la préparation d'un matériau reprographique photosensible, dans lequel on applique sur un support de couche une couche reprographique photosensible selon la revendication 1, et on applique une couche de recouvrement sur cette couche reprographique, caractérisé en ce que, pour la production de la couche de recouvrement, on applque et sèche sur la couche reprographique une dispersion aqueuse stable d'un polymère insoluble dans l'eau.

**Claims**

1. Light-sensitive recording material comprising a support, a light-sensitive recording layer which contains, as the light-sensitive compound, a condensation product comprising recurrent units $A-N_2X$ and B which are linked by divalent intermediate members derived from a carbonyl compound which is capable of condensation, the units $A-N_2X$ being derived from compounds of the genral formula

$$(R^1-R^3-)_pR^2-N_2X$$

in which

X is the anion of the diazonium compound,

p is an integer from 1 to 3,

$R^1$ is a carbocyclic or heterocyclic aromatic radical which is capable of condensation in at least one position,

$R^2$ is an arylene group of the benzene or naphthalene series,

$R^3$ is a single bond or one selected from the group consisting of:

$$-(CH_2)_q-NR^4-,\quad -O-(CH_2)_r-NR^4-,\quad -S-(CH_2)_r-NR^4-,$$

$$-S-CH_2-CO-NR^4-,\quad -O-R^5-O-,\quad -O-,$$

$$-S,\ \text{and}\ -CO-NR^4-,$$

wherein

q is an integer from 0 to 5,

r is an integer from 2 to 5,

$R^4$ is a hydrogen atom, an alkyl group having from 1 to 5 carbon atoms, an aralkyl group having from 7 to 12 carbon atoms or an aryl group having from 6 to 12 carbon atoms, and

$R^5$ is an arylene group having from 6 to 12 carbon atoms and

B denoting the radical of an aromatic amine, a phenol, a thiophenol, a phenol ether, an aromatic thioether, an aromatic hydrocarbon, an aromatic heterocyclic compound or an organic acid amide, which is free from diazonium groups,

the condensation product containing, on an average, from 0.01 to 50 units B for each unit $A-N_2X$, and as the binder, a water-insoluble polymer which is soluble in aqueous-alkaline solutions, and a covering layer which contains a water-insoluble homopolymer or copolymer of an alkyl acrylate or an alkyl methacrylate having from 1 to 12 carbon atoms in the alkyl group, of a vinyl ester of a carboxylic acid having from 2 to 12 carbon atoms, of a vinyl alkyl ether having from 2 to 8 carbon atoms in the alkyl group or of a vinyl-aromatic compound having from 8 to 12 carbon atoms and which is present on top of the light-sensitive recording layer, wherein the covering layer has been produced by coating with a stable aqueous dispersion of the water-insoluble homopolymer or copolymer and drying.

2. A recording material as claimed in claim 1, wherein the covering layer contains, in addition to the water-insoluble polymer, a diazonium salt condensation product according to the definition given in claim 1.

3. A recording material as claimed in claim 1, wherein the covering layer has a layer weight from 0.2 to 1 $g/m^2$.

4. A recording material as claimed in claim 1, wherein the covering layer additionally contains a surface-active agent.

5. A recording material as claimed in claim 1, wherein the covering layer additionally contains a protective colloid.

6. Process for the production of a light-sensitive recording material, which comprises coating a support with a light-sensitive recording layer as claimed in claim 1 and applying a covering layer to this recording layer, wherein the covering layer is produced by coating the recording layer with a stable aqueous dispersion of a water-insoluble polymer and drying.